# EUROPEAN PATENT SPECIFICATION

(11) **EP 2 852 269 B1**
(45) Date of publication and mention of the grant of the patent: **30.10.2019**
(21) Application number: 14275195.7
(22) Date of filing: 19.09.2014
(51) Int. Cl.: H05K 7/20

(54) **Electronic assembly casing and electronic assembly**
Gehäuse einer elektronischen Baugruppe und elektronische Baugruppe
Ensemble électronique et boîtier d'ensemble électronique

(30) Priority: 19.09.2013 GB 201316628
(43) Date of publication of application: 25.03.2015
(73) Proprietor: Quixant PLC, Balsham, Cambridgeshire CB21 4EP (GB)
(72) Inventor: Jarmany, Nicholas Charles Leopold, Chislehurst, Kent (GB)
(74) Representative: Williams Powell

(56) References cited:
- US-A1- 2011 122 578

## Description

### Field of the Invention

The present invention relates to an electronic assembly casing and electronic assembly that are particularly suited to for use in gaming and gambling machines - often referred to as "slot machines".

### Background of the Invention

It is also usually necessary for gaming and gambling machines such as slot machines to comply with certain standards set by government, state or other regulatory bodies relating to the security of the slot machines, as they handle significant revenue streams. There are normally security requirements to ensure that the machines are not tampered with, either to manipulate payouts to users or the recording of transactions for the purpose of collecting government gaming taxes from machine operators. This is in addition to protection from physical attacks aimed at stealing money contained within the machines. Usually, this protection includes physical security to prevent unauthorised access to the interior of the slot machine and especially the "logic box" that houses the computer system and the operating programs.

In recent years there has been a trend in the slot machine industry to migrate from low performance, low power computer technologies to a PC standard architecture. This has greatly improved the performance of slot games but has introduced another problem. Computer architecture systems generally consume much more power and therefore generate more heat.

The heat produced by PC based computer systems is clearly an issue. Conventional PC cases with fans mounted around hot components or at vents generally do not meet the physical security requirements discussed above.

Not only is it desirable to produce systems that can efficiently disperse generated heat while remaining secure, there is also a general desire in the industry to improve security where possible and provide additional reassurance to owners, users and regulators that the logic box that houses the all-important computer system and operating programs has not been tampered with.

US 2011/0122578 discloses an electronic device with a heat dissipation module.

### Summary of the Invention

According to an aspect of the present invention, there is provided an electronic assembly casing as claimed in claim 1.

Preferably, the heat sink cage is part of one of the walls.

Preferably, the heat sink cage is arranged to extend from the circuit board, when mounted, about a perimeter of the heat sink.

Preferably, the casing further comprises a coupling member to couple the heat sink cage to the circuit board and/or heat sink about said perimeter.

The coupling member may include an adhesive to adhere the heat sink cage to the circuit board about said perimeter.

The coupling member may comprise a foam body having said adhesive on a portion of the body that faces and adheres to said perimeter of the circuit board when the circuit board is mounted.

At least one of the walls of the trench may be non-perpendicular to said first plane.

One of the walls of the trench may be a wall of said heat sink cage.

The trench preferably includes a first trench wall extending from said first plane toward said surface of said circuit board, a second trench wall that is
substantially co-planar to said surface of said circuit board and a third trench wall, the third trench wall comprising the wall of the heat sink cage.

The first and third trench walls may be at substantially mirror opposite angles with respect to the second trench wall.

The heat sink cage may include a plurality of heat vents.

Preferably, the casing comprises a plastics body. The plastics body may be substantially transparent.

The heat sink cage may be formed by at least a part of one of the walls of the casing.

According to another aspect of the present invention, there is provided an electronic assembly comprising an electronic assembly casing as described above and a circuit board mounted to the circuit board mount, the circuit board including a heat sink that extends from the circuit board into the heat sink cage of the casing.

The present invention seeks to provide an improved electronic assembly casing for a printed circuit board such as a computer, logic box or other electronic assembly for use, for example, in a gaming device. The present invention also seeks to provide an improved electronic assembly including such a case.

Advantageously, an electronic assembly casing according to embodiments of the present invention can be formed from substantially non-heat-conducting materials such as plastics. Unlike conventional casings that typically select materials based on heat conductivity, casing materials in embodiments of the present invention can be selected for properties such as weight and ability to be attractively coloured or patterned and/or moulded in non-box-like shapes.

In preferred embodiments, the casing can be formed substantially entirely from transparent plastics to enable a user, owner or regulator to visually reassure themselves, while the electronic assembly is installed and in potentially is use, that the electronics assembly (such as a circuit board) contained in the casing is standard and has not been tampered with or includes unexpected components or connections.

In preferred embodiments, the heat sink cage is substantially sealed to the circuit board about a perimeter of the heat sink. While the heat sink is exposed to the outside world and could theoretically be physically accessed via the vents such as slots, mesh or apertures in the case, the actual electronic components are protected by the heat sink and/or the seal and cannot themselves be accessed. As such, a heat generating electronic assembly can be accommodated in a casing that substantially prevents physical access to electronic components of the assembly from the outside world whilst enabling heat to be dissipated via the heat sink.

In preferred embodiments, a trench is formed around the heat sink cage to allow air to flow over substantially the entirety of a surface of a heat sink accommodated by the cage.

It will be appreciated that multiple cages, potentially in multiple different walls of the casing could be provided for different heat sinks.

### Brief Description of the Drawings

Embodiments of the present invention are described below, by way of example only, with reference to the accompanying drawings, in which:
Figure 1 shows a perspective view of an electronics assembly casing according to one embodiment;
Figures 2 and 3 are, respectively, top and side views of the casing of Figure 1;
Figure 4 is a cross-sectional view of the casing of Figure 1 showing aspects of a mounted electronic circuit board; and,
Figure 5 is a perspective view of the interior of the casing of Figure 1 showing an example circuit board mounted in place.

### Detailed Description

In the following description, terms such as "top", "base", "front" and "rear" are used. It will be appreciated that these do not impart any particular required orientation of the described element and are simply relative terms referring to the illustrated element. The terms are not to be interpreted as restrictions and the element could, for example, be turned over or onto its side so that the "top"0 is no longer at the top.

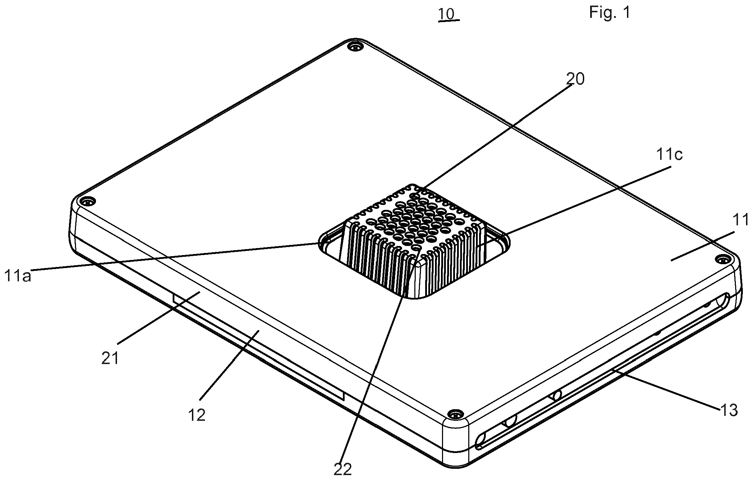

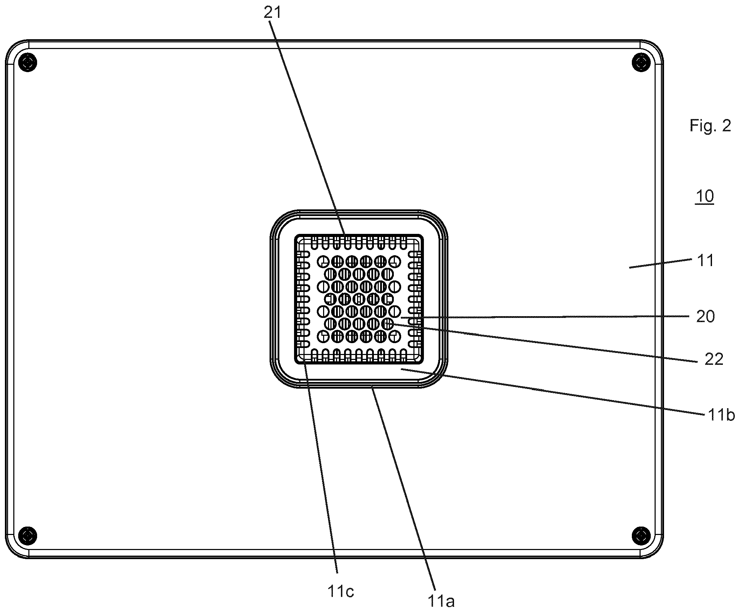

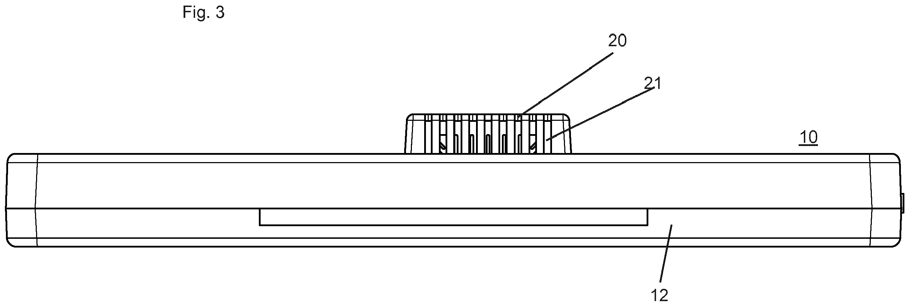

Figure 1 shows a perspective view of an electronic assembly casing according to one embodiment. Figures 2 and 3 are, respectively, top and side views of the casing of Figure 1.

The electronic assembly casing 10 has walls 11, 12, 13 (rear and base walls not shown) which define an internal chamber. The size and shape of the casing is shown purely for exemplary purposes and could be varied depending on the intended application and end use. Although a box-shaped casing is shown, the casing could be of any size, shape, design or proportion.

A heat sink cage 20 is formed as part of the top wall 11. The heat sink cage 20 includes a plurality of heat vents 21, 22 in the form of slots 21 and circular holes 22.

In the illustrated embodiment, the heat sink cage 20 projects above the top wall 11.

In a preferred embodiment, the top wall 11 slopes (11a) down into the casing towards the base wall (not shown) before flattening out (11b) and then rising back out (11c) to form the cage 20. This forms a trench 11a-11c that runs around the perimeter of the cage 20 and provides for improved airflow around the heat sink cage 20. The heat sink cage is preferably formed as part of one of the walls (as opposed to being a separate component and joined or otherwise connected to the casing).

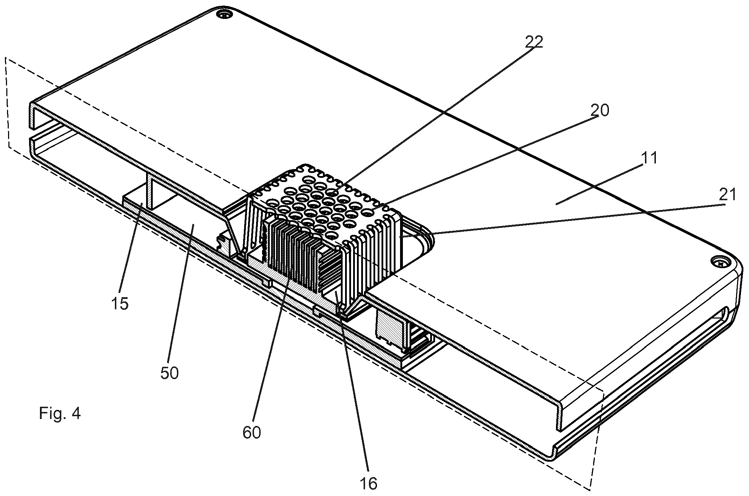

Figure 4 is a cross-sectional view of the casing 10 of Figure 1 showing aspects of a mounted electronic circuit board 50.

The casing 10 includes a circuit board mount 15 to mount the circuit board 50 in the internal chamber. The circuit board 50 includes a heat sink 60 which is positioned in the heat sink cage 20 when the circuit board is mounted on the circuit board mount 15.

Preferably, the heat sink cage 20 is arranged to extend from the circuit board 50, when mounted, about a perimeter of the heat sink. Most preferably, the heat sink cage 20 sits on or couples to the circuit board 50 about said perimeter such that all that is within the caged area is the heat sink, as can be seen in Figure 4. As the heat sink sits on top of heat producing elements such as processors, it acts as physical block/protection to those elements. The heat sink cage 20 being connected to the circuit board around the trench area prevents someone trying to physically access other elements of the circuit board 50 via the heat vents 21, 22. The trench 11a-11c therefore provides a thermal and mechanical (security) barrier between the area in and around the heat sink and the remainder of the chamber inside the casing.

In one embodiment, the heat sink cage is coupled to the circuit board by a coupling member. In one embodiment, the coupling member includes an adhesive 16 to adhere the heat sink cage to the circuit board about said perimeter.

In a preferred embodiment, the coupling member includes a foam body such as a foam gasket, strip or pad, optionally having adhesive on a portion of the body that faces and adheres to said perimeter of the circuit board when the circuit board is mounted.

In preferred embodiments, the foam gasket sits beneath the base of the trench (11b) and fills any gap between the bottom of the trench in the case and the surface of the circuit board and/or the base of the heat sink (depending on whether the foam gasket couples to the circuit board or to a portion of the heat sink). This arrangement allows any irregular gaps that may be present in that area to be filled and serves as a barrier to air heated by the heat sink from entering the main chamber inside of the casing. It will be appreciated that the gasket is optional if the gap is minimal between the bottom of the trench in the case and the base of the heat sink or surface of the circuit board.

Use of a foam body enables forces from the heat sink cage to be at least partially absorbed by compression or stretching of the foam rather than being directly applied to the board or adhesive connection.

In a preferred embodiment, the casing has a plastics body. In one embodiment, the plastics body is substantially transparent.

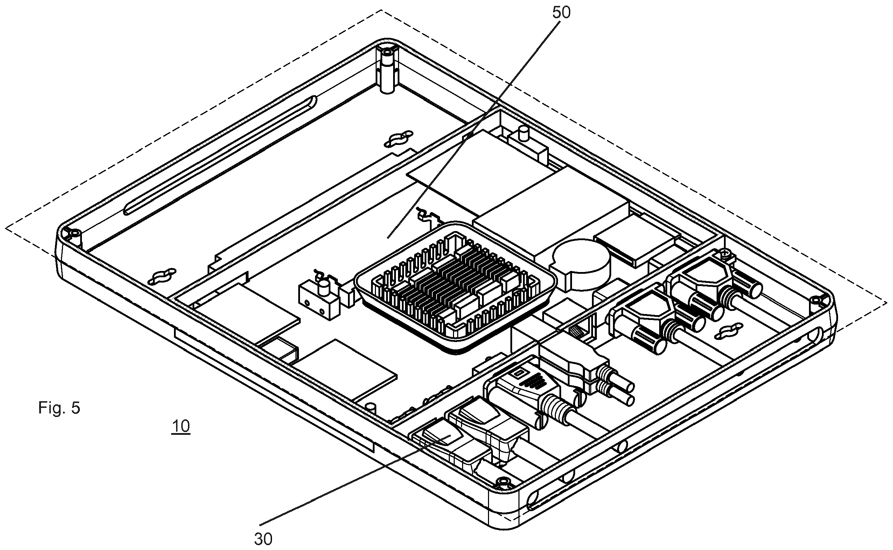

Figure 5 is a perspective view of the interior of the casing of Figure 1 showing an example circuit board mounted in place.

The casing 10 preferably also includes a number of input/output connector access ports 30 which match to input/output connectors of the circuit board when mounted (again, in preferred embodiments the casing and connectors between them block physical access into the internal chamber of the casing in which the electronics of the circuit board is housed.

Advantageously in such an arrangement, only the heat sink and the input/output ports are physically accessible from outside the casing 10.

It will be appreciated that the components of the circuit board and their position can be varied. The elements and input/output connectors are shown purely for illustration purposes.

Indeed, although the general position and size of the heat sink cage is dependent on the position of the heat sink of the circuit board, the design of the casing or cage could be varied to suit the board. Multiple circuit board mounts (or a sliding and locking mechanism) could be provided to allow the circuit board to be laterally shifted within the casing during mounting so as to best fit the heat sink in the cage. In another alternative, the casing may be provided as a kit of parts with multiple "top" walls, each with a different size/position of cage so as to accommodate different board configurations.

It will be appreciated that the casing may be provided ready to receive an appropriate circuit board 50 or it could be assembled and sold as a ready to use component. Indeed, while the casing is flexible so as to allow different circuit boards to be accommodated, a key advantage is in the ability to be able to use plastics materials and indeed transparent plastics materials for applications where heat-producing components are provided with a mechanism for heat venting but are still protected from physical tampering from the exterior of the casing.

## Claims

1. An electronic assembly casing (10) having walls (11, 12, 13) providing an internal chamber and a circuit board mount (15) to mount a circuit board (50) in the internal chamber, the casing further comprising a heat sink cage (20) in one of said walls (11) to accommodate a heat sink (60) of the circuit board (50) when mounted on the circuit board mount (15), the heat sink cage (20) being in a first wall (11) of the casing (10) that extends, when the circuit board (50) is mounted, in a first plane substantially parallel to a surface of the circuit board (50) mounting the heat sink (60), the first wall (11) further defining a trench (11a-c) about said cage (60), the trench (11a-c) extending from said first plane toward said surface of said circuit board (50).

2. An electronic assembly casing (10) as claimed in claim 1, wherein the heat sink cage (20) is part of one of the walls (11, 12, 13).

3. An electronic assembly casing as claimed in claim 1 or 2, wherein the heat sink cage (20) is arranged to extend from the circuit board (50), when mounted, about a perimeter of the heat sink (20).

4. An electronic assembly casing (10) as claimed in claim 3, further comprising a coupling member to couple the heat sink cage (20) to the circuit board (50) and/or heat sink (60) about said perimeter.

5. An electronic assembly casing (10) as claimed in claim 4, wherein the coupling member includes an adhesive to adhere the heat sink cage (20) to the circuit board (50) about said perimeter.

6. An electronic assembly casing (10) as claimed in claim 5, wherein the coupling member comprises a foam body having said adhesive on a portion of the body that faces and adheres to said perimeter of the circuit board (50) when the circuit board (50) is mounted.

7. An electronic assembly casing (10) as claimed in any of claims 4, 5 or 6, wherein the coupling member and the casing mechanically segregate the circuit board (50) within said perimeter from a remainder of the circuit board (50).

8. An electronic assembly casing (10) as claimed in and preceding claim, wherein at least one of the walls (11a;11c) of the trench is non-perpendicular to said first plane.

9. An electronic assembly casing (10) as claimed in claim 8, wherein one of the walls (11c) of the trench is a wall of said heat sink cage (20).

10. An electronic assembly casing (10) as claimed in claim 9, wherein the trench includes a first trench wall (11a) extending from said first plane toward said surface of said circuit board (50), a second trench wall (11b) that is substantially co-planar to said surface of said circuit board (50) and a third trench wall (11c), the third trench wall (11c) comprising the wall of the heat sink cage (20).

11. An electronic assembly casing (10) as claimed in claim 10, wherein the first (11a) and third (11c) trench walls are at substantially mirror opposite angles with respect to the second trench wall (11b).

12. An electronic assembly casing (10) as claimed in any preceding claim, wherein the casing comprises a plastics body.

13. An electronic assembly casing (10) as claimed in claim 12, wherein the plastics body is substantially transparent.

14. An electronic assembly comprising an electronic assembly casing (10) as claimed in any preceding claim and a circuit board (50) mounted to the circuit board mount, the circuit board including a heat sink (60) that extends from the circuit board (50) into the heat sink cage (20) of the casing (10).

## Patentansprüche

1. Gehäuse (10) für eine elektronische Baugruppe mit Wänden (11, 12, 13), die eine Innenkammer und eine Leiterplattenhalterung (15) zum Befestigen einer Leiterplatte (50) in der Innenkammer bereitstellen, wobei das Gehäuse ferner eine Wärmesenke umfasst Käfig (20) in einer der Wände (11) zur Aufnahme eines Kühlkörpers (60) der Leiterplatte (50) bei Montage auf der Leiterplattenhalterung (15), wobei sich der Kühlkörperkäfig (20) in einer ersten Wand befindet (11) des Gehäuses (10), das sich, wenn die Leiterplatte (50) montiert ist, in einer ersten Ebene erstreckt, die im Wesentlichen parallel zu einer Oberfläche der Leiterplatte (50) ist, auf der der Kühlkörper (60) montiert ist, wobei die erste Wand (11) Weiteres Definieren eines Grabens (11a-c) um den Käfig (60), wobei sich der Graben (11a-c) von der ersten Ebene in Richtung der Oberfläche der Leiterplatte (50) erstreckt.

2. Gehäuse (10) für eine elektronische Baugruppe nach Anspruch 1, wobei der Kühlkörperkäfig (20) Teil einer der Wände (11, 12, 13) ist.

3. Gehäuse für eine elektronische Baugruppe nach Anspruch 1 oder 2, wobei der Kühlkörperkäfig (20) so angeordnet ist, dass er sich im montierten Zustand von der Leiterplatte (50) um einen Umfang des Kühlkörpers (20) erstreckt.

4. Gehäuse (10) für eine elektronische Baugruppe nach Anspruch 3, das ferner ein Kopplungselement umfasst, um den Kühlkörperkäfig (20) mit der Leiterplatte (50) und / oder dem Kühlkörper (60) um den Umfang herum zu koppeln.

5. Gehäuse (10) für eine elektronische Baugruppe nach Anspruch 4, wobei das Kopplungselement einen Klebstoff enthält, um den Kühlkörperkäfig (20) an der Leiterplatte (50) um den Umfang herum zu befestigen.

6. Gehäuse (10) für eine elektronische Baugruppe nach Anspruch 5, wobei das Kopplungselement einen Schaumkörper umfasst, der den Klebstoff auf einem Abschnitt des Körpers aufweist, der dem Umfang der Leiterplatte (50) gegenüberliegt und an diesem haftet, wenn sich die Leiterplatte befindet (50) montiert ist.

7. Gehäuse (10) für eine elektronische Baugruppe nach einem der Ansprüche 4, 5 oder 6, wobei das Kopplungselement und das Gehäuse die Leiterplatte (50) innerhalb des Umfangs mechanisch von einem Rest der Leiterplatte (50) trennen.

8. Gehäuse (10) für eine elektronische Baugruppe nach einem der vorhergehenden Ansprüche, wobei mindestens eine der Wände (11a; 11c) des Grabens nicht senkrecht zu der ersten Ebene ist.

9. Gehäuse (10) für eine elektronische Baugruppe nach Anspruch 8, wobei eine der Wände (11c) des Grabens eine Wand des Kühlkörperkäfigs (20) ist.

10. Gehäuse (10) für eine elektronische Baugruppe nach Anspruch 9, wobei der Graben eine erste Grabenwand (11a) umfasst, die sich von der ersten Ebene in Richtung der Oberfläche der Leiterplatte (50) erstreckt, und eine zweite Grabenwand (11b), die sich von der ersten Ebene in Richtung der Oberfläche der Leiterplatte (50) erstreckt ist im wesentlichen koplanar zu der Oberfläche der Leiterplatte (50) und einer dritten Grabenwand (11c), wobei die dritte Grabenwand (11c) die Wand des Kühlkörperkäfigs (20) aufweist.

11. Gehäuse (10) für eine elektronische Baugruppe nach Anspruch 10, wobei die erste (11a) und die dritte (11c) Grabenwand in Bezug auf die zweite Grabenwand (11b) im Wesentlichen spiegelverkehrt sind.

12. Gehäuse (10) für eine elektronische Baugruppe nach einem der vorhergehenden Ansprüche, wobei das Gehäuse einen Kunststoffkörper umfasst.

13. Gehäuse (10) für eine elektronische Baugruppe nach Anspruch 12, wobei der Kunststoffkörper im Wesentlichen transparent ist.

14. Elektronische Baugruppe, umfassend ein Gehäuse (10) für eine elektronische Baugruppe nach einem der vorhergehenden Ansprüche und eine Leiterplatte (50), die an der Leiterplattenhalterung angebracht ist, wobei die Leiterplatte eine Wärmesenke (60) enthält, die sich von der Leiterplatte aus erstreckt (50) in den Kühlkörperkäfig (20) des Gehäuses (10).

## Revendications

1. Boîtier d'assemblage électronique (10) ayant des parois (11, 12, 13) fournissant une chambre interne et un support de carte de circuit imprimé (15) pour monter une carte de circuit imprimé (50) dans la chambre interne, le boîtier comprenant en outre un dissipateur de chaleur une cage (20) dans l'une desdites parois (11) pour loger un dissipateur de chaleur (60) de la carte de circuit imprimé (50) lorsqu'elle est montée sur le montage de carte de circuit imprimé (15), la cage de dissipateur de chaleur (20) se trouvant dans une première paroi (11) du boîtier (10) qui s'étend, lorsque la carte de circuit imprimé (50) est montée, dans un premier plan sensiblement parallèle à une surface de la carte de circuit imprimé (50) portant le dissipateur de chaleur (60), la première paroi (11) définissant en outre une tranchée (11a-c) autour de ladite cage (60), la tranchée (11a-c) s'étendant depuis ledit premier plan en direction de ladite surface de ladite carte de circuit imprimé (50).

2. Boîtier d'assemblage électronique (10) selon la revendication 1, dans lequel la cage de dissipateur de chaleur (20) fait partie de l'une des parois (11, 12, 13).

3. Boîtier d'assemblage électronique selon la revendication 1 ou 2, dans lequel la cage de dissipateur de chaleur (20) est agencée pour s'étendre depuis la carte de circuit imprimé (50), lorsqu'elle est montée, sur un périmètre du dissipateur de chaleur (20).

4. Boîtier d'assemblage électronique (10) selon la revendication 3, comprenant en outre un élément de couplage pour coupler la cage de dissipateur de chaleur (20) à la carte de circuit imprimé (50) et / ou au dissipateur de chaleur (60) autour dudit périmètre.

5. Boîtier d'assemblage électronique (10) selon la revendication 4, dans lequel l'élément de couplage comprend un adhésif pour faire adhérer la cage de dissipateur de chaleur (20) à la carte de circuit imprimé (50) autour dudit périmètre.

6. Boîtier d'assemblage électronique (10) selon la revendication 5, dans lequel l'élément de couplage comprend un corps en mousse comportant ledit adhésif sur une partie du corps qui fait face et adhère audit périmètre de la carte de circuit imprimé (50) lorsque la carte de circuit imprimé (50) est monté.

7. Boîtier d'assemblage électronique (10) selon l'une quelconque des revendications 4, 5 ou 6, dans lequel l'élément de couplage et le boîtier séparent mécaniquement la carte de circuit imprimé (50) dans ledit périmètre du reste de la carte de circuit imprimé (50).

8. Boîtier d'assemblage électronique (10) selon l'une des revendications précédentes, dans lequel au moins l'une des parois (11a; 11c) de la tranchée est non perpendiculaire audit premier plan.

9. Boîtier d'assemblage électronique (10) selon la revendication 8, dans lequel l'une des parois (11c) de la tranchée est une paroi de ladite cage de dissipateur de chaleur (20).

10. Boîtier d'assemblage électronique (10) selon la revendication 9, dans lequel la tranchée comprend une première paroi de tranchée (11a) s'étendant depuis ledit premier plan vers ladite surface de ladite carte de circuit imprimé (50), une seconde paroi de tranchée (11b) qui est sensiblement coplanaire à ladite surface de ladite carte de circuit (50) et d'une troisième paroi de tranchée (11c), la troisième paroi de tranchée (11c) comprenant la paroi de la cage de dissipateur de chaleur (20).

11. Boîtier d'assemblage électronique (10) selon la revendication 10, dans lequel les première (11a) et troisième (11c) parois de tranchée forment des angles sensiblement opposés aux miroirs par rapport à la seconde paroi de tranchée (11b).

12. Boîtier d'assemblage électronique (10) selon l'une quelconque des revendications précédentes, dans lequel le boîtier comprend un corps en matière plastique.

13. Boîtier d'assemblage électronique (10) selon la revendication 12, dans lequel le corps en matière plastique est sensiblement transparent.

14. Ensemble électronique comprenant un boîtier (10) d'ensemble électronique selon l'une quelconque des revendications précédentes et une carte de circuit imprimé (50) montée sur le montage de carte de circuit imprimé, la carte de circuit imprimé comprenant un dissipateur de chaleur (60) qui s'étend à partir de la carte de circuit imprimé (50) dans la cage du dissipateur de chaleur (20) du boîtier (10).
